# EUROPEAN PATENT SPECIFICATION

(11) **EP 0 430 514 B1**
(45) Date of publication and mention of the grant of the patent: **31.01.1996**
(21) Application number: 90312517.7
(22) Date of filing: 16.11.1990
(51) Int. Cl.: H01L 21/20

(54) **Substantially facet free selective epitaxial growth process**
Verfahren zum selektiven epitaxialen Wachstum, das hauptsächlich keine Seitenfläche aufweist
Procédé de croissance épitaxiale substantiellement exempte de facettes

(30) Priority: 27.11.1989 US 441807
(43) Date of publication of application: 05.06.1991
(73) Proprietor: AT&T Corp., New York, NY 10013-2412 (US)
(72) Inventor: Feygenson, Anatoly, Reading, Pennsylvania 19606 (US); Osenbach, John William, Sinking Springs, Pennsylvania 19608 (US); Schimmel, Donald George, Reading, Pennsylvania 19605 (US)
(74) Representative: Johnston, Kenneth Graham

(56) References cited:
- FR-A- 2 595 507
- US-A- 4 522 662
- US-A- 4 592 792
- JOURNAL OF THE ELECTROCHEMICAL SOCIETY, vol. 133, no. 6, June 1986, pages 1274-1275, Manchester, NH, US; R.P. ZINGG et al.: "Epitaxial lateral overgrowth of silicon over steps of thick Si02"
- IDEM
- JAPANESE JOURNAL OF APPLIED PHYSICS, vol. 28, no. 5.I, May 1989, pages 841-848,Tokyo, JP; A. ISHITANI et al.: "Silicon selective epitaxial growth andelectrical properties of epi/sidewall interfaces"
- APPLIED PHYSICS LETTERS, vol. 55, no. 24, 11th December 1989, pages 2544-2546,American Institute of Physics, New York, US; D. PRIBAT et al.: "Conformal vaporphase epitaxy"
- EXTENDED ABSTRACTS/ELECTROCHEMICAL SOCIETY, vol. 87-2, 1987, pages 1500-1501,Princeton, New Jersey, US; H.M. LIAW et al.: "Silicon selective epitaxy forhigh speed pedestal-type bipolar devices"

## Description

### Background of the Invention

### Field of the Invention

This invention relates to silicon epitaxial growth processes, and more particularly, to selective epitaxial growth processes for integrated circuit fabrication.

### Description of the Prior Art

Selective epitaxial growth on silicon wafers is used to form isolated regions of silicon in which devices may be formed, such as bipolar and field-effect transistors. The primary advantages gained by having isolated regions are the reduced parasitic capacitive coupling of the devices to the substrate and the excellent inter-isolation of devices formed in different regions. These advantages allow for higher speed and higher operating voltages than attainable in circuits fabricated using prior-art isolation techniques, such as the local oxidation of silicon process (LOCOS) widely used in CMOS circuit fabrication.

In general, the formation of the selective epitaxial regions or layers on a wafer involves opening windows in an oxide layer to expose the underlying substrate. This is done with conventional photolithographic techniques and anisotropic etching, such as a reactive ion etch (RIE). The wafer is then placed in a reactor and silicon is grown, and the desired dopant is simultaneously incorporated therewith, to form the epitaxial regions on the exposed substrate. However, typical processes allow for only about 0.6 micrometer of silicon growth before significant faceting (here, 0.1 micrometer or more) occurs on the major surface of the epitaxial region. As will be discussed in more detail below, faceting is the formation of another growth plane at a different angle from the major surface of the region, typically forming at the sides of the region where it meets the wall of the oxide layer. The plane of the facet is along a different crystallographic plane than the major surface of the epitaxial region. As will be discussed in more detail below, such faceting reduces the amount of area on the major surface of the epitaxial region available for fabrication of a device for a given region size. Further, the limitation of 0.6 micrometer of epitaxial region thickness limits the operating voltage of the devices formed in the region before break-down of the device to the substrate occurs.

Another difficulty with typical selective growth process is the need to modify the process depending on the amount of silicon substrate area exposed on the wafer for the selective epitaxial layers to be grown. These variations are necessary so that the growth rate and, hence, the degree of facet formation, is controlled to give the desired thickness of the layer before significant faceting occurs. A consequence of this process variation is the inability of one reactor using this process to simultaneously grow consistent thickness epitaxial regions on wafers having different amounts of exposed silicon thereon.

According to the present invention, there is provided a method as defined in claim 1.

It is one aspect of the invention to provide a method of selectively growing an epitaxial layer of a thickness which may exceed 0.6 micrometer without significant faceting.

It is another aspect of the invention to provide a method of selectively growing substantially consistent thickness epitaxial layers on wafers, with differing amounts of exposed silicon, in one reactor.

These and other aspects of the invention are provided for generally by a method of growing selective epitaxial layers on at least one silicon substrate in a reactor, the substrate covered with a masking layer having openings therein to expose portions of the substrate where an epitaxial layer is to be grown, characterized by the step of: flowing hydrogen, hydrochloric acid (HCl), and a silicon source gas (SiClₓH_{y}) over the substrate at predetermined flow rates; wherein the temperature of the gases and substrate is at least about 900°C and less than about 1100°C, the flow rate of the hydrogen at least about 15 SLM and no more than about 180 SLM, and the flow rate of the silicon source gas is at least about 50 SCCM and no more than about 150 SCCM the flow rate of the hydrochloric acid ranges from at least about 100 SCCM to no more than 420 SCCM, and the pressure in the reactor is less than about 80 hPa.

### Brief Description of the Drawing

The foregoing features of this invention, as well as the invention itself, may be more fully understood from the following detailed description of the drawings, in which:

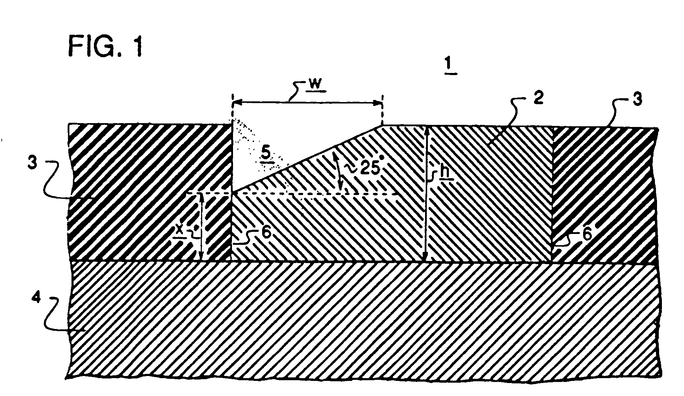

FIG. 1 is a cross-section (not to scale) of a selective epitaxial layer showing the faceting thereof.

### Detailed Description

FIG. 1 shows a cross-section (not to scale) of a silicon structure 1 having a selective epitaxial region or layer 2 in an opening of oxide 3, the opening being defined by the sidewalls 6. The epitaxial layer 2 is grown on a substrate 4, preferably by a process described below. The process by which the structure 1 is formed prior to the growth of the selective epitaxial layer 2 was described above. Where the layer 2 meets the sidewall 6 of oxide 3, here silicon dioxide, a facet 5 is shown. Typically, when grown at 900°-1100°C, the facet forms a plane having an angle of about 25° from the normal to the wall 6 of the oxide 3. For purposes here, the total height of the layer 2 is designated as h and the height of the layer 2 prior to the formation of the facet 5 is designated as x. Typically, the height of the oxide 3 is substantially equal to the height h of the layer 2.

As can be seen from FIG. 1, the facet 5 decreases the amount of planar surface available on the major surface of the layer 2 by the amount shown here as w. Hence, w ≈( h - x)/tan 25°, where h - x is the amount of faceting. In order to decrease w, and thereby increase the usable planar surface area on the major surface of layer 2, it is desirable to make the height x to be as close to the height h as possible prior to the facet 5 forming.

### Preferred Embodiments

A wafer to have at least one selective epitaxial growth thereon has windows formed in the oxide layers 3 in a conventional manner, as described above, so as to expose portions of the substrate 4. The portions so exposed are etched to remove any residual surface damage that may have occurred during the opening of the windows, such as by RIE. The etch to remove the residual damage is preferably done by subjecting the wafer in a dilute mixture of HF and H₂O in HNO₃, The etchant is approximately a 10:1 mixture of H₂O and HF diluted with HNO₃ at about a 4-10 to 400 ratio, used over a temperature range of about 20° to 40°C. Preferably, about a 6 to 400 ratio (H₂O:HF to HNO₃) is used at a temperature of about 25°C.

The wafer, along with other similarly processed wafers, is next placed in a a conventional epitaxial reactor, such as an AMI 7810, made by Applied Materials, Inc., of Fremont, California. The wafer is heated to approximately 1025°C in an atmosphere of H₂ at a flow rate of approximately 125 standard liters per minute (SLM) and at a pressure of less than about 80 hPa (60 Torr), preferably about 1.3 to 73 hPa (1 to 55 Torr), for approximately five minutes. This substantially removes any native oxide that may have formed on the exposed portion of substrate 4.

The temperature is then adjusted to the below-listed exemplary preferred processing parameters (shown in parenthesis) and the corresponding reactive gasses (the Si source gas and HCI) are introduced into the reactor:

**TABLE 1**

| Si Source | Si Source flow rate in SCCM (Preferred rate) | HCl flow rate in SCCM (Preferred rate) | H₂ flow rate in SLM (Preferred rate) | Temp °C (Preferred temp) | Growth rate µ/min |
|---|---|---|---|---|---|
| SiCl₂H₂ | 50 - 150 (80) | 300 - 420 (330) | 15 - 180 (125) | 900 - 960 (950) | 0.5 - 0.7 |
| SiCl₄ | 50 - 150 (80) | 150 - 210 (165) | 15 - 180 (125) | 1025 - 1100 (1050) | 0.4 - 0.5 |
| SiCl₃H | 50 - 150 (80) | 200 - 300 (220) | 15 - 180 (125) | 950 - 1060 (1010) | 0.6 - 0.9 |

The reactive gases (Si source and HCl) remain on until the desired thickness of the silicon epitaxial layer 2 is grown. It is noted that the higher growth rates apply for those wafers with the ratio of the total amount of silicon substrate 4 area exposed to the total area of the substrate, expressed as a percentage, of greater than approximately 16%. Consequently, the lower growth rates apply to smaller percentages of total substrate exposure. It is noted that the disparity is not a large one, and a median growth rate may be used for growth time calculations. This makes the process relatively insensitive to exposure percentages, compared to the prior art. It is preferable, however, to group wafers together in one reactor by exposure percentage to achieve better control of the resulting epitaxial layer 2 thickness. This grouping may be divided by those with exposure greater than, and those with exposure less than, 16%.

Once the reactive gases are turned off, except the hydrogen, the reactor is allowed to ramp down in temperature to approximately 850°C. Then the hydrogen is turned off and the reactor purged with nitrogen until room temperature is reached. The wafers may then be processed using conventional device fabrication techniques to form silicon devices in the layer 2, such as bipolar and field-effect transistors, resistors, capacitors, diodes, etc.

It is understood that the temperatures, pressures, and flow rates shown in Table 1 are all approximate and may be varied within the ranges shown. However, it has been found that the ratio of Si to free HCI is important to the proper growth of the epitaxial layer 2. The ratio of Si to free HCI may range from about 1:5 to 1:8 and is preferably approximately 1:6, or one silicon atom for every six hydrochloric acid molecules, for a substantially minimum facet formation. The source of free HCl is controlled by the amount of chlorine combined with silicon in the silicon source gas and the amount of HCl gas introduced. The chlorine introduced by the silicon source gas is converted to free HCl due to the high temperatures (>900°C) and the abundance of hydrogen from the hydrogen gas. Therefore, depending on the amount of chlorine in the silicon source gas, the amount of HCI introduced controls the ratio of silicon to free HCl.

The length of time for the reactive gases to be present is dependent on the above-given exemplary growth rates and the desired thickness of the so grown epitaxial layers. It is further understood that the desired dopants, such as phosphorus, boron, antimony, or arsenic, may be introduced during the epitaxial layer growth process to grow the layers with the desired conductivity and resistivity.

Due to the relatively low free HCl concentration compared to that in the prior art, it has been found that the facet formation on a epitaxial layer grown using the above-given flow rates is relatively insensitive to the crystallographic plane of the substrate. But it may be preferable to grow the epitaxial layers on a substrate oriented in a <100>, <111>, or <311> direction for best (i.e., a thicker layer before faceting) results.

### Experimental Results

Using the first set of exemplary preferred processing parameters with silicon dichlorosilane (SiCl₂H₂), 6% of the substrate exposed by openings in a mask, and a pressure of approximately 73 hPa (55 Torr), epitaxial layers of approximately 1.2 microns thick were formed with only 0.1 micrometers of faceting ( h - x of FIG. 1) occurring.

## Claims

1. A method of growing selectively epitaxial layers on selected portions of at least one silicon substrate, the substrate covered with a masking layer having openings therein to expose said portions of the substrate where an epitaxial layer is to be grown, characterized by the step of:
flowing hydrogen, hydrochloric acid (HCl), and a silicon source gas (SiCl ₓ H_{y}) over the substrate at predetermined flow rates;
wherein the temperature of the gases and substrate is at least about 900°C and less than about 1100°C, the flow rate of the hydrogen at least about 15 SLM and no more than about 180 SLM, the flow rate of the silicon source gas is at least about 50 SCCM and no more than about 150 SCCM, the flow rate of the hydrochloric acid ranges from at least about 100 SCCM to no more than 420 SCCM, and the pressure in the reactor is less than about 80 hPa (60 Torr).

2. The method of growing selective epitaxial layers as recited in claim 1, wherein the range of the flow rate of the hydrochloric acid is such that the ratio of silicon atoms to chlorine atoms in the reactor ranges from about one-to-five to about one-to-eight.

3. The method of growing selective epitaxial layers as recited in claim 2, wherein the silicon source gas is SiCl₂ H₂, the flow rate for the hydrochloric acid ranges from at least about 300 SCCM to no more than about 420 SCCM, and the temperature ranges from at least about 900°C to no more than about 960°C.

4. The method of growing selective epitaxial layers as recited in claim 2, wherein the silicon source gas is SiCl₃H, the flow rate for the hydrochloric acid ranges from at least about 200 SCCM to no more than about 350 SCCM, and the temperature ranges from at least about 950°C to no more than about 1100°C.

5. The method of growing selective epitaxial layers as recited in claim 2, wherein the silicon source gas is SiCl₄, the flow rate for the hydrochloric acid ranges from at least about 100 SCCM to no more than about 150 SCCM, and the temperature ranges from at least about 1025°C to no more than about 1100°C.

## Patentansprüche

1. Verfahren zum selektiven Aufwachsen epitaxialer Schichten an ausgewählten Abschnitten von wenigstens einem Siliciumsubstrat, wobei das Substrat mit einer Maskierungsschicht mit Öffnungen in dieser zum Freilegen der Abschnitte des Substrats, an welchem die epitaxiale Schicht aufzuwachsen ist, bedeckt ist,
gekennzeichnet durch die Schritte des Strömenlassens von Wasserstoff, Salzsäure (HCl) und eines Siliciumquellengases (SiCl_{X}H_{Y}) über das Substrat bei vorbestimmten Strömungsgeschwindigkeiten, wobei die Temperatur des Gases und des Substrates wenigstens oberhalb von 900°C und niedriger als ungefähr 1100°C ist, wobei die Strömungsgeschwindigkeit des Wasserstoffs wenigstens ungefähr 15 SLM und nicht mehr als ungefähr 180 SLM, die Strömungsgeschwindigkeit des Siliciumquellengases wenigstens 50 SCCM und nicht mehr als ungefähr 150 SCCM beträgt, wobei die Strömungsgeschwindigkeit der Salzsäure von wenigstens ungefähr 100 SCCM bis zu nicht mehr als 420 SCCM reicht, und der Druck in dem Reaktor weniger als ungefähr 80 hPa (60 Torr) beträgt.

2. Verfahren zum Aufwachsen ausgewählter epitaxialer Schichten nach Anspruch 1,
bei welchem der Bereich der Strömungsgeschwindigkeit der Salzsäure so ist, daß das Verhältnis von Siliciumatomen zu Chloratomen in dem Reaktor von ungefähr 1:5 bis zu ungefähr 1:8 reicht.

3. Verfahren zum Aufwachsen ausgewählter epitaxialer Schichten nach Anspruch 2,
bei welchem das Siliciumquellengas SiCl₂H₂ ist, die Strömungsgeschwindigkeit der Salzsäure von wenigstens ungefähr 300 SCCM bis zu nicht mehr als ungefähr 420 SCCM reicht und die Temperatur von wenigstens ungefähr 900°C bis zu nicht mehr als ungefähr 960°C reicht.

4. Verfahren zum Aufwachsen ausgewählter epitaxialer Schichten nach Anspruch 2,
bei welchem das Siliciumquellengas SiCl₃H ist, die Strömungsgeschwindigkeit für die Salzsäure von wenigstens 200 SCCM bis zu nicht mehr als ungefähr 350 SCCM reicht und die Temperatur von wenigstens 950°C bis zu nicht mehr als ungefähr 1100°C reicht.

5. Verfahren zum Aufwachsen ausgewählter epitaxialer Schichten nach Anspruch 2,
bei welchem das Siliciumquellengas SiCl₄ ist, die Strömungsgeschwindigkeit der Salzsäure von wenigstens ungefähr 100 SCCM bis zu nicht mehr als ungefähr 150 SCCM reicht und die Temperatur von wenigstens ungefähr 1025°C bis zu nicht mehr als ungefähr 1100°C reicht.

## Revendications

1. Un procédé de croissance sélective de couches épitaxiales sur des parties sélectionnées d'au moins un substrat en silicium, ce substrat étant recouvert par une couche de masquage ayant à l'intérieur des ouvertures pour mettre à nu les parties précitées du substrat dans lesquelles on doit faire croître une couche épitaxiale, caractérisé par l'étape suivante :
on fait circuler sur le substrat, avec des débits prédéterminés, de l'hydrogène, de l'acide chlorhydrique (HCl) et un gaz de source de silicium (SiCl_{X}H_{Y});
dans des conditions dans lesquelles la température des gaz et du substrat est au moins d'environ 900°C et est inférieure à environ 1100°C, le débit de l'hydrogène, en valeur normalisée, est au moins d'environ 15 L/min et n'est pas supérieur à environ 180 L/min, le débit du gaz de source de silicium, en valeur normalisée, est au moins d'environ 50 cm³/min et n'est pas supérieur à environ 150 cm³/min, le débit de l'acide chlorhydrique, en valeur normalisée, est compris dans une plage allant d'au moins environ 100 cm³/min jusqu'à une valeur ne dépassant pas 420 cm³/min, et la pression dans le réacteur est inférieure à environ 80 hPa (60 Torr).

2. Le procédé de croissance de couches épitaxiales sélectives selon la revendication 1, dans lequel la plage du débit de l'acide chlorhydrique est telle que le rapport des atomes de silicium aux atomes de chlore dans le réacteur est compris dans une plage allant d'environ un à cinq jusqu'à environ un à huit.

3. Le procédé de croissance de couches épitaxiales sélectives selon la revendication 2, dans lequel le gaz de source de silicium consiste en SiCl₂H₂, le débit de l'acide chlorhydrique, en valeur normalisée est compris entre au moins environ 300 cm³/min et une valeur ne dépassant pas environ 420 cm³/min, et la température est comprise dans une plage allant d'au moins environ 900°C jusqu'à une valeur ne dépassant pas environ 960°C.

4. Le procédé de croissance de couches épitaxiales sélectives selon la revendication 2, dans lequel le gaz de source de silicium consiste en SiCl₃H, le débit de l'acide chlorhydrique, en valeur normalisée, est compris dans une plage allant d'au moins environ 200 cm³/min jusqu'à une valeur ne dépassant pas environ 350 cm³/min, et la température est comprise dans une plage allant d'au moins environ 950°C jusqu'à une valeur ne dépassant pas environ 1100°C.

5. Le procédé de croissance de couches épitaxiales sélectives selon la revendication 2, dans lequel le gaz de source de silicium consiste en SiCl₄, le débit de l'acide chlorhydrique, en valeur normalisée, est compris dans une plage allant d'au moins environ 100 cm³/min jusqu'à une valeur ne dépassant pas environ 150 cm³/min, et la température est comprise dans une plage allant d'au moins environ 1025°C jusqu'à une valeur ne dépassant pas environ 1100°C.
